Europäisches Patentamt

European Patent Office

Office européen des brevets

(19)

(11) **EP 1 199 756 A2**

(12) ## EUROPEAN PATENT APPLICATION

(43) Date of publication:
**24.04.2002 Bulletin 2002/17**

(51) Int Cl.7: **H01L 33/00**

(21) Application number: **01124255.9**

(22) Date of filing: **16.10.2001**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(30) Priority: **18.10.2000 JP 2000317270**<br>**31.10.2000 JP 2000332637**<br><br>(71) Applicant: **Sumitomo Chemical Company, Limited**<br>**Chuo-ku Osaka 541-8550 (JP)** | (72) Inventors:<br>• **Ono, Yoshinobu**<br>  **Tsukuba-gun, Ibaraki (JP)**<br>• **Hata, Masahiko**<br>  **Tsuchiura-shi, Ibaraki (JP)**<br>• **Tani, Takeshi**<br>  **Ushiku-shi, Ibaraki (JP)**<br><br>(74) Representative: **VOSSIUS & PARTNER**<br>**Siebertstrasse 4**<br>**81675 München (DE)** |

(54) **3-5 group compound semiconductor and light-emitting element**

(57)     Provided is a 3-5 group compound semiconductor comprising a GaAs substrate, a buffer layer on said GaAs substrate and an epitaxial crystal layer on said buffer layer, and the dislocation density in the epitaxial crystal layer on said buffer layer is $2000/cm^2$ or less. The properties and reliability of an electronic device or optical device can be remarkably improved.

Figure 1

## Description

The present invention relates to a 3-5 group compound semiconductor obtained by epitaxial crystal growth of a 3-5 group compound semiconductor on a GaAs substrate, and a light-emitting element using the same.

Compound semiconductors of this kind have a laminated structure of epitaxial crystal layers of 3-5 group compound semiconductor on a GaAs substrate, and for example, light emitting elements, which is widely used, have a laminated structure consisting of an $Al_{0.20}Ga_{0.80}As$ acting as a light emitting layer (active layer) and an $Al_{0.5}Ga_{0.5}As$ layer acting as a barrier layer (clad layer) on a GaAs substrate, to give red light emission. Optical devices of this kind have a characteristic that the overflow of injected electrons and halls is suppressed by large potential barrier owing to band gap discontinuity obtained by hetero junction, consequently, high light emitting efficiency can be attained. Though optical devices are exemplified for illustrations in the above, in addition to them, electronic devices such as HBT(hetero junction bipolar transistors) and HEMT(high electron mobile transistors) have also a laminated structure of epitaxial crystal layers of 3-5 group compound semiconductor on a GaAs substrate.

When semiconductor devices having a laminated structure of epitaxial crystal layers on a GaAs substrate are produced, dislocation density in the epitaxial crystal layers becomes a problem. Namely, the dislocation density in the epitaxial crystal layers is closely related with device properties and reliability, and if the dislocation density is large, the quality of a produced device deteriorates problematically. For example, in the case of an optical device such as a light emitting diode, when the dislocation density is large, a problem occurs that life time and reliability of the device fall down simultaneously, and additionally, light emitting intensity also falls down.

The main cause of the dislocation occurring in an epitaxial crystal layer is based on a mechanism that, in a process of epitaxial growth, the dislocation originated in the GaAs substrate propagates into the epitaxial crystal layer.

Therefore, various methods for lowering dislocation density of GaAs substrate have been conventionally tried, such as a method of decreasing heat stress, namely, temperature gradient, in production of a GaAs substrate and a method of increasing critical shearing stress.

However, when the dislocation density of a GaAs substrate is tried to be lowered by the above-mentioned methods, manufacturing cost may become disadvantageous, further, there is a limitation to reduction of the dislocation, consequently, it is difficult to raise the properties and reliability of devices to high levels.

## SUMMARY OF THE INVENTION

An object of the present invention is to overcome the above-mentioned problems and to improve the properties and reliability of an electronic device or optical device. This object could be achieved by growing 3-5 group compound semiconductors as a buffer layer on a GaAs substrate, and as an epitaxial crystal layer on said buffer layer, represented independently by the general formula $In_xGa_yAl_zAs$ (wherein, $0 \leq x \leq 1$, $0 \leq y \leq 1$, $0 \leq z \leq 1$, x+y+z=1), and by suppressing the dislocation density in the grown epitaxial crystal layer lower than the dislocation density in the GaAs substrate.

A first subject-matter of the present invention is a 3-5 group compound semiconductor comprising a GaAs substrate, a buffer layer on said GaAs substrate and an epitaxial crystal layer on said buffer layer, said layers being formed by an epitaxial crystal growth method, wherein said buffer layer and said epitaxial crystal layer on said buffer layer are 3-5 group compound semiconductors each independently represented by the general formula $In_xGa_yAl_zAs$ (wherein, $0 \leq x \leq 1$, $0 \leq y \leq 1$, $0 \leq z \leq 1$, x+y+z=1), and the dislocation density in the epitaxial crystal layer on said buffer layer is 2000/cm² or less.

A second subject-matter of the present invention is a 3-5 group compound semiconductor comprising a GaAs substrate, a buffer layer on said GaAs substrate and an epitaxial crystal layer on said buffer layer, said layers being formed by an epitaxial crystal growth method, wherein said buffer layer and said epitaxial crystal layer on said buffer layer are 3-5 group compound semiconductors each independently represented by the general formula $In_xGa_yAl_zAs$ (wherein, $0 \leq x \leq 1$, $0 \leq y \leq 1$, $0 \leq z \leq 1$, x+y+z=1), and the dislocation density in said epitaxial crystal layer on the buffer layer is 1/3 or less of the dislocation density in said GaAs substrate.

Fig. 1 is a sectional view showing the structure of one embodiment of the 3-5 group compound semiconductor of the present invention.

Fig. 2 is a sectional view showing the structure of Comparative Example 1, a 3-5 group compound semiconductor having no buffer layer.

Figure 3 is a sectional view of the structure of Referential Example 1.

The denotations used in the Figures are as follows.

    1: Thin film crystal wafer
    2: GaAs substrate
    3: Buffer layer
    4: Optical device layer
    7,13: i-AlGaAs layer
    8,12: n-AlGaAs layer
    9,11: i-AlGaAs layer
    10: i-InGaAs layer
    31: $Al_{0.2}Ga_{0.8}As$ layer
    32: GaAs layer

41: Clad layer ($Al_{0.4}Ga_{0.6}As$ layer)
42: Active layer ($Al_{0.15}Ga_{0.85}As$ layer)
43: Clad layer ($Al_{0.4}Ga_{0.6}As$ layer)
44: Contact layer

The present invention will be explained with referring to the drawings.

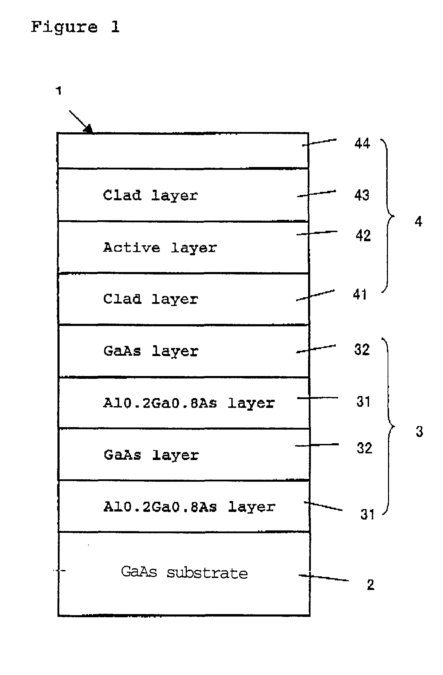

Fig. 1 is a sectional view showing one embodiment of an optical device according to the invention. The thin film crystal wafer 1 is used for producing a semiconductor light emitting element, and formed by sequentially growing a plurality of epitaxial crystal layers on a semi-insulating GaAs substrate 2 using an Organic metal vapor phase epitaxy (hereafter, referred to as OMVPE) method.

The buffer layer 3 is grown by allowing a 3-5 group compound semiconductor represented by the general formula $In_xGa_yAl_zAs$ (wherein, $0 \leqq x \leqq 1$, $0 \leqq y \leqq 1$, $0 \leqq z \leqq 1$, x+y+z=1) to grow on a GaAs substrate using an OMVPE method. Here, two kinds of layers, $Al_{0.2}Ga_{0.8}As$ layer 31 and GaAs layer 32 each having a thickness of 10 nm are grown twice, and by this, the buffer layer 3 is endowed with a superlattice structure.

In this embodiment, a buffer layer 3 which consist of superlattice structure is grown on a GaAs substrate 2, and a optical device layer 4 having a double hetero structure is grown on the buffer layer 3, and by this constitution, propagation of dislocation from the GaAs substrate 2 into the optical device layer 4 is suppressed, and the dislocation density in the optical device layer 4 is controlled to a level sufficiently smaller than the dislocation density in the GaAs substrate 2.

The optical device layer 4 has double hetero structure composed of a clad layer ($Al_{0.4}Ga_{0.6}As$ layer) 41, active layer ($Al_{0.15}Ga_{0.85}As$ layer) 42 and a clad layer ($Al_{0.4}Ga_{0.6}As$ layer) 43, and a contact layer 44 is formed on the uppermost part.

The buffer layer is composed of two or more kinds of epitaxial crystal layers having different compositions, however, the crystal layers may have three or more compositions. The composition of a layer constituting the buffer layer 3 can be appropriately selected from those represented by the general formula $In_xGa_yAl_zAs$ (wherein, $0 \leqq x \leqq 1$, $0 \leqq y \leqq 1$, $0 \leqq z \leqq 1$, x+y+z=1), and as exemplified in Fig. 1, a combination of two kinds of compositions, $Ga_{l-z}Al_zAs$ ($0 < z \leqq 1$) and GaAs, is preferable. In the case of a combination of two kinds of compositions, $Ga_{l-z}Al_zAs$ and GaAs, it is particularly preferable that z is 0.01 or more and 0.4 or less for effectively suppressing propagation of dislocation.

Though the repetition number of two or more kinds of epitaxial crystal layers having different compositions in the buffer layer is two in the embodiment of Fig. 1, it is preferable that the repetition number is larger, since an effect of suppressing propagation of dislocation in the GaAs substrate into an upper layer is higher when this repetition number is larger. Judging from experiments, though a repetition number of one gives a sufficient effect, the repetition number may be appropriately selected in a range from 1 to 30, preferably from 2 to 20 so as to give desired dislocation density.

The epitaxial crystal layers having different compositions in the buffer layer can be allowed to grow alternately to have given thickness on the GaAs substrate, and by this, the buffer layer having a superlattice structure can be formed. The thickness of the layer is not especially limited, and can be appropriately selected in a range from 0.5 nm to 500 nm, preferably from 5 nm to 50 nm. They may have different layer thicknesses.

In this embodiment, by doping an n-type dopant into at least one layer constituting the buffer layer, propagation of dislocation from the GaAs layer into an upper layer can be suppressed more effectively as compared with a case of no doping. As the n-type dopant, Si, Ge, Sn and Pb are exemplified, and among them, Si is preferable.

The doping concentration of n-type dopant is not restricted especially, and can be appropriately selected in a range from $1 \times 10^{17}$ cm$^{-3}$ to $1 \times 10^{19}$ cm$^{-3}$ to attain a desired effect. The doping concentration is preferably $1 \times 10^{17}$ cm$^{-3}$ to $5 \times 10^{18}$ cm$^{-3}$, and more referably $5 \times 10^{17}$ cm$^{-3}$ to $5 \times 10^{18}$ cm$^{-3}$. Thus, when an n-type dopant is doped into any one layer constituting the buffer layer, having a superlattice structure, dislocation can be terminated due to an effect of disturbance in a crystal potential field around the n-type dopant atom, consequently, propagation of dislocation toward an upper layer from the GaAs substrate can be more effectively suppressed.

Doping is conducted uniformly into a layer constituting a buffer layer as above, however, as the additional method, so-called planar-doping can be effected, in which doping is conducted only on a specific plane in the layer, to obtain the same effect. The position of a plane on which planar-doping is effected may be inside of the layers or at the interface of two kinds of layers. At any position, the concentration of planar-doping is effectively and preferably $1 \times 10^{11}$ cm$^{-2}$ or more and $5 \times 10^{12}$ cm$^{-2}$ or less.

Thus, when the buffer layer is grown on the GaAs substrate, propagation of dislocation through the buffer layer is suppressed, consequently, the dislocation density in the optical device layer grown on the buffer layer can be decreased irrespective of the dislocation density of the GaAs substrate. As a result, the probability of occurrence of element deterioration can be reduced, and a problem of shortening of element life due to gradual progress of crystal defects with the lapse of time, in the optical device layer, can be solved. Further, since crystal lattice defects can be reduced, irradiative recombination decreases, and the light-emitting efficiency increases. Therefore, when light-emitting devices such as LED, laser diode and the like are made based on this constitution, a high performance optical device having longer life and higher reliability can be provided.

For enabling confirmation of reduction of dislocation density by provision of the above-mentioned buffer layer, an optical device layer of known constitution for measuring PL is formed.

Several methods for measurement of dislocation density are known in the prior art.

Transmission electron microscope (TEM) method is useful for the measurement, and permits the direct observation and even the characterization of dislocations. Nevertheless, the method has problems such as a narrow field of view, a destructive test, the necessity of skill and time in sample preparation, and a difficulty in observing the samples of low dislocation density.

X-ray topography method is also useful for the measurement, and similarly permits the direct observation and even the characterization of dislocations. Nevertheless, the method has the problem of necessity of skill and time in measurement and a difficulty in application to samples of higher dislocation density.

In etch pit counting method, an etch pit is formed at the site where a dislocation reach the crystal surface, by a specific agent (etchant). Then, the number of etch pits is counted, whereby its density gives the dislocation density.

Nevertheless, the etchant needs adjustment depending on the epitaxial crystal composition, thereby causing an extra time for searching the appropriate condition. Further, the method is not applicable to chemically stable crystals for which no effective etchant exists. The method has also a difficulty in application to samples of higher dislocation density and the problem of destructive test.

Cathode luminescence (CL) method uses the phenomenon that the intensity of luminescent light induced by electron beam irradiation is weak in the vicinity of dislocations. In the obtained luminescence intensity map, the number of dark spots or dark lines is counted, whereby its density gives the dislocation density. In the method, the sample is inserted into a scanning electron microscope unit, and this causes generally a necessity of breaking the sample, and hence, it is a destructive test. The method further has problems that only a narrow field can be observed and an application to a sample having lower dislocation density is difficult.

As above, in the prior art methods, there have been problems that a wide range of dislocation density from low to high cannot be covered by a single method, and further, it is difficult to measure simply and non-destructively.

In the present invention, as the method of measurement of dislocation density in an epitaxial crystal, it becomes possible to cover a wide range of dislocation density from low to high by utilizing a photoluminescence method, and further it permits a nondestructive, rapid, and easy measurement.

That is, in the present invention, provided is a method of measurement of dislocation density in an epitaxial crystal comprising the steps of; irradiating an epitaxial crystal with laser light having a wavelength shorter than that corresponding to the band gap energy of the crystal composition; measuring the in-surface distribution of the peak intensity of thus-obtained photoluminescent light. The dislocation density ($N$ cm$^{-2}$) is calculated from the number ($n$) of dark spots or dark lines and the area ($S$ cm$^2$) of measurement region, according to the following formula (I).

$$N=n/S \qquad (I)$$

The method of measurement of dislocation density uses the phenomenon that in photoluminescence (hereafter, referred to as PL), PL intensity is very weak in the regions where dislocation exists. More specifically, when a dislocation line is perpendicular to the surface, the region is recognized as a dark spot. In contrast, when a dislocation line is parallel to the surface, the region is recognized as a dark line. Further, when a dislocation line is at an angle $\alpha$ ($0° <\alpha<90°$) relative to the surface, or when a dislocation parallel to the surface bends into perpendicular or inclined configuration relative to the surface, the region is recognized as a dark line segment.

For example, an epitaxial-layer dislocation having a dislocation line at an angle $\alpha$ ($0° <\alpha\leqq90°$) relative to the surface generally originates from a dislocation in the substrate. A higher dislocation density in the substrate causes a higher dislocation density in the epitaxial layer and hence a higher dark spot density.

Further, a dislocation having a dislocation line parallel to the surface is generally what is called a misfit dislocation. This is caused by the lattice distortion resulted from the difference between the lattice constants of the stacked layer and the substrate. A larger difference in lattice constant causes a higher misfit dislocation density and hence a higher dark line density. In the invention, the number of these dark spots and dark lines is counted from the PL intensity map, whereby the dislocation density is obtained.

The method of measurement of dislocation density by means of PL mapping according to the invention is an optical and nondestructive detection method, and hence permits easy and rapid evaluation. Further, in the method, a movable sample stage permits arbitrary selection of the region and position of measurement.

Further, with variable monitoring wavelength, the method of measurement of dislocation density by means of PL mapping is applicable to a wide range of crystal composition. The wavelength for the PL intensity monitoring is generally set to be the main peak wavelength in the PL light. When a plurality of PL peaks each having a diverse wavelength are emitted from a plurality of layers in a multi-layer epitaxial crystal, mapping can be carried out in each wavelength. This gives the dislocation density in each layer and hence information on the change in dislocation density.

The laser light used for the excitation in PL mapping needs to have a photon energy greater than the band gap energy of the crystal. Any kind of laser satisfying this requirement can be used. For example, lasers applicable to GaAs, AlGaAs, and InGaAs are an Ar laser and a secondary harmonics YAG laser. Further, for nitride semiconductors such as GaN and InGaN, a HeCd laser can be used preferably.

It is important to set the PL mapping conditions, especially, laser spot size, measurement point spacing, and measurement region area, appropriately to the size and thickness of dislocations (dark spots and dark lines) to be detected by PL. The size of dark spots is in the order of photo-carrier diffusion length which is characteristic to the crystal.

The laser spot size is preferably set to be in the order of the size of dark spots, or the photo-carrier diffusion length. Even when the laser spot size is smaller than the photo-carrier diffusion length, the carriers generated by the laser irradiation diffuse into a region in the order of photo-carrier diffusion length. This prevents the improvement in spatial resolution. In contrast, inappropriately large laser spot size causes degradation in spatial resolution and PL signal intensity, thereby undesirably increasing the noise.

With dark spot size d ($\mu$m) and laser spot diameter D ($\mu$m), preferable laser spot diameter is in the order of 0.1d <D<30d. Thus, the preferable laser spot diameter is 1-100 $\mu$m for e.g. GaAs and AlGaAs semiconductor crystals, and 0.3$\mu$m to a few $\mu$m for e.g. GaN and InGaN semiconductor crystals.

Measurement point spacing is preferably set to be in the order of laser spot diameter or smaller. A measurement point spacing greater than the laser spot diameter prevents the measurement of overall surface, and hence is undesirable. A measurement point spacing smaller than the laser spot diameter gives more detailed intensity distribution. Nevertheless, an extremely small measurement point spacing causes an extremely long measurement time, and hence is undesirable. Preferable measurement point spacing L is in the order of 0.01D<L<D.

The method of counting the dark spots may be any of the method of direct counting from the map or the method of image analysis.

Measurement region area is set to be an appropriate size depending on the dislocation density of sample, that is, the density of dark spots and dark lines. The preferable number of dark spots is 1-1000, while the preferable number of dark lines is 1-100. Numbers outside these ranges can cause a problem in counting accuracy. Thus, the measurement region area is preferably set so that the counted numbers fall within the ranges. From the measurement region area (S cm$^2$) of PL mapping and the counted number (n) of dark spots or dark lines, the dislocation density (N cm$^{-2}$) is obtained according to the following formula.

$$N=n/S$$

EXAMPLES

The invention is described below in detail but it should be noted that the invention is not restricted to these examples.

Example 1

The 3-5 group compound semiconductor epitaxial multi-layers (buffer layer 3) having the superlattice structure shown in Figure 1 were grown on the (100) surface of a GaAs substrate by means of OMVPE. After the growth of the buffer layer 3, the epitaxial crystal layers (optical device layer 4) of double heterostructure were grown for the PL measurement.

The repetition number of superlattice was 10. The layer compositions were $Al_{0.2}Ga_{0.8}As$ and GaAs. The thickness of each layer was 10 nm. The GaAs layers in the superlattice were doped with Si at a doping density of $2 \times 10^{18}$ cm$^{-3}$.

The dislocation density of the epitaxial crystal layers (optical device layer 4) was measured by means of PL mapping using a secondary harmonics YAG laser. More specifically, the monitoring wavelength was 760 nm equal to the peak wavelength of the PL light. The laser spot diameter was approximately 30 $\mu$m. The measurement point spacing was 10 $\mu$m. The scanned measurement region was $2 \times 2$ mm. The peak intensity was mapped, whereby the dislocation density was obtained from the number of dark spots present in the region. The measurement was carried out at two positions each in the center and in the periphery of the epitaxial wafer. The average number of dark spots was 1.9, thereby having given the dislocation density of 47 cm$^{-2}$. The dislocation density of the GaAs substrate 2 used herein was about 5000 cm$^{-2}$ based on evaluation by an etch pit method.

Example 2

Buffer layer 3 and the epitaxial crystal layers (optical device layer 4) were grown by the same method as in Example 1 except that the Si doping concentration was $1 \times 10^{18}$ cm$^{-3}$, and the dislocation density of the epitaxial crystal layer (optical device layer 4) was evaluated according to PL mapping, to find a value of 147 cm$^{-2}$.

Example 3

Buffer layer 3 and the epitaxial crystal layers (optical device layer 4) were grown by the same method as in Example 1 except that Si doping was not conducted. The dislocation density of the epitaxial crystal layer (optical device layer 4) was evaluated according to PL mapping, to find a value of 340 cm$^{-2}$.

Example 4

Buffer layer 3 and the epitaxial crystal layers (optical device layer 4) were grown by the same method as in Example 1 except that the repetition number of the buffer layer 3 was 5. The dislocation density of the epitaxial crystal layer (optical device layer 4) was evaluated according to PL mapping, to find a value of 105 cm$^{-2}$.

Example 5

Buffer layer 3 and the epitaxial crystal layers (optical device layer 4) were grown by the same method as in Example 4 except that the Si doping concentration was $1\times10^{18}$ cm$^{-3}$, and the dislocation density of the epitaxial crystal layer (optical device layer 4) was evaluated according to PL mapping, to find a value of 325 cm$^{-2}$.

Example 6

Buffer layer 3 and the epitaxial crystal layers (optical device layer 4) were grown by the same method as in Example 4 except that Si doping was not conducted. The dislocation density of the epitaxial crystal layer (optical device layer 4) was evaluated according to PL mapping, to find a value of 726 cm$^{-2}$.

Example 7

An epitaxial laminated film was grown by the same method as in Example 1 except that the number of lamination of the buffer layer 3 was 1. The dislocation density of the epitaxial crystal layer (optical device layer 4) was evaluated according to PL mapping, to find a value of 258 cm$^{-2}$.

Example 8

Buffer layer 3 and the epitaxial crystal layers (optical device layer 4) were grown by the same method as in Example 7 except that the Si doping concentration was $1\times10^{18}$ cm$^{-3}$. The dislocation density of the epitaxial crystal layer (optical device layer 4) was evaluated according to PL mapping, to find a value of 802 cm$^{-2}$.

Example 9

Buffer layer 3 and the epitaxial crystal layers (optical device layer 4) were grown by the same method as in Example 9 except that Si doping was not conducted. The dislocation density of the epitaxial crystal layer (optical device layer 4) was evaluated according to PL mapping, to find a value of 1880 cm$^{-2}$.

Example 10

Buffer layer 3 and the epitaxial crystal layers (optical device layer 4) were grown by the same method as in Example 1 except that the composition of the superlattice was (Al$_{0.35}$Ga$_{0.65}$As/GaAs:Si). The dislocation density of the epitaxial crystal layer (optical device layer 4) was evaluated according to PL mapping, to find a value of 202 cm$^{-2}$.

Example 11

Buffer layer 3 and the epitaxial crystal layers (optical device layer 4) were grown by the same method as in Example 10 except that the Si doping concentration was $1\times10^{18}$ cm$^{-3}$. The dislocation density of the epitaxial crystal layer (optical device layer 4) was evaluated according to PL mapping, to find a value of 627 cm$^{-2}$.

Example 12

Buffer layer 3 and the epitaxial crystal layers (optical device layer 4) were grown by the same method as in Example 10 except that Si doping was not conducted. The dislocation density of the epitaxial crystal layer (optical device layer 4) was evaluated according to PL mapping, to find a value of 1470 cm$^{-2}$.

Example 13

Buffer layer 3 and the epitaxial crystal layers (optical device layer 4) were grown by the same method as in Example 1 excepting the following points in the Si doping method. In the Si doping, the Al$_{0.2}$Ga$_{0.8}$As layer 31 was grown, then, planar-doping was effected at a concentration of $1\times10^{12}$ cm$^{-2}$ at the interface with the following GaAs layer 32, subsequently, the GaAs layer 32 was allowed to grow. The dislocation density of the epitaxial crystal layer (optical device layer 4) was evaluated according to PL mapping, to find a value of 138 cm$^{-2}$.

Example 14

Buffer layer 3 and the epitaxial crystal layers (optical device layer 4) were grown by the same method as in Example 1 except that the dislocation density of the GaAs substrate used was about 50000 cm$^{-2}$. The dislocation density of the epitaxial crystal layer (optical device layer 4) was evaluated according to PL mapping, to find a value of 550 cm$^{-2}$.

Comparative Example 1

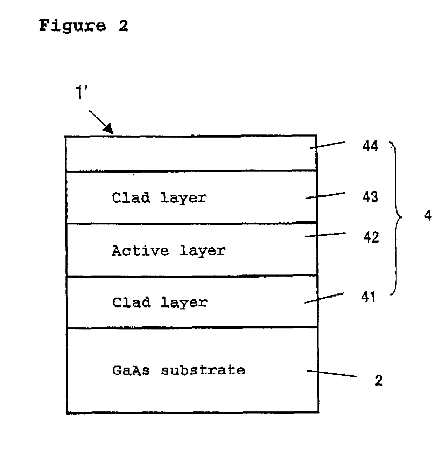

As shown in Fig. 2, in a 3-5 group compound semiconductor 1' produced by growing the optical device layer 4 directly on the GaAs substrate 2 without providing the buffer layer 3 having a laminated structure for reducing the dislocation density, the dislocation density of the optical device layer 4 was evaluated according to PL mapping. Here, the constitution for the GaAs substrate 2 and the optical device layer 4 were the same as in Example 1, as a result, the dislocation density of the optical device layer 4 was 3400 cm$^{-2}$. It is known from this Comparative Example 1 that the dislocation density of a epitaxial crystal layers grown on the GaAs substrate 2 can be remarkably reduced by providing the buffer layer 3. Further, it is also known that the dislocation density can be further reduced by doping Si into the buffer layer 3 and selecting a suitable value of this doping concentration.

Thus, by providing the buffer layer 3, or by doping an n-type dopant into the buffer layer 3 in addition to this, propagation of dislocation into an upper layer can be effectively prevented, consequently, the dislocation density of an epitaxial crystal layers grown on the GaAs substrate 2 can be decreased even if a GaAs substrate 2 having large dislocation density is used. Therefore, if this constitution is used in production a optical device such as a light-emitting element, degree of freedom in selecting substrates increases, and the produced light-emitting element can be endowed with longer life and high reliability, further, an element excellent in properties having high light-emitting efficiency can be realized.

Referential Example 1

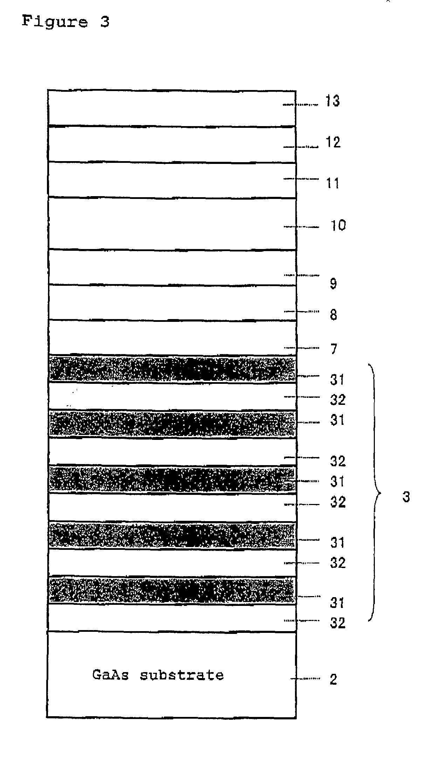

The 3-5 group compound semiconductor epitaxial multi-layers having the structure shown in Figure 3 were fabricated on the (100) surface of a GaAs substrate by means of OMVPE. Five pairs of superlattice each pair composed of an Al$_{0.2}$Ga$_{0.8}$As layer of 50 nm and a GaAs layer of 50 nm were grown onto a GaAs layer of 150 nm. Further, a HEMT structure having an electron transporting layer of In$_{0.22}$Ga$_{0.8}$As layer of 14 nm was grown thereon for the PL measurement.

The presence of misfit dislocations caused by the lattice mismatch between the In$_{0.22}$Ga$_{0.8}$As layer and each adjacent Al$_{0.2}$Ga$_{0.8}$As layer was evaluated by means of PL mapping using a secondary harmonics YAG laser. Specifically, the monitoring wavelength was 1080 nm equal to the peak wavelength of the PL light of the In$_{0.22}$Ga$_{0.8}$As layer. The laser spot diameter was approximately 30 μm. The measurement point spacing was 10 μm. The scanned measurement region was 2×2 mm. Under these conditions, the peak intensity was mapped. The result of the PL mapping has revealed the presence of dark lines in two directions approximately perpendicular to each other. The dark lines in one direction were of line shape, whereas the dark lines in the other direction were of line segment shape. No dark spot was found. The counted number of dark lines was 26, thereby having given the misfit dislocation density of 650 cm$^{-2}$

After that, in order to investigate the PL from the Al$_{0.2}$Ga$_{0.8}$As/GaAs superlattice buffer layer, the intensity mapping was carried out with a monitoring wavelength of 840 nm equal to the PL peak wavelength of GaAs layer. The result has revealed the presence of dark lines in a pattern and a number similar to those of the In$_{0.22}$Ga$_{0.8}$As mapping.

Referential Example 2

A HEMT structure was grown under a condition similar to that of Referential Example 1 except for the change in the In composition from 0.22 to 0.2. The presence of misfit dislocations caused by the lattice mismatch between the In$_{0.2}$Ga$_{0.8}$As layer and each adjacent Al$_{0.2}$Ga$_{0.8}$As layer was evaluated by means of PL mapping using a secondary harmonics YAG laser. Specifically, the monitoring wavelength was 1050 nm equal to the peak wavelength of the PL light of the In$_{0.2}$Ga$_{0.8}$As layer. The laser spot diameter was approximately 30 μm. The measurement point spacing was 10 μm. The scanned measurement region was 2×2 mm. Under these conditions, the peak intensity was mapped. The result of the PL mapping has revealed the absence of dark lines and the presence of dark spots alone. The number of dark spots was 19, thereby having given the dislocation density of 475 cm$^{-2}$.

After that, in order to investigate the PL from the Al$_{0.2}$Ga$_{0.8}$As/GaAs superlattice, the intensity mapping was carried out with a monitoring wavelength of 840 nm equal to the PL peak wavelength of GaAs layer. The result has revealed the absence of dark lines and the presence of dark spots alone, similarly to the case of In$_{0.2}$Ga$_{0.8}$As mapping. The number of dark spots was 103, thereby having given the dislocation density of 2575 cm$^{-2}$.

The method of measurement of dislocation density permits nondestructive, rapid, and easy measurement of the dislocation density in an epitaxial crystal layers, in a wide range of dislocation density from low to high.

If the structure of the 3-5 group compound semiconductor of the present invention is used, the dislocation density in epitaxial crystal layers can be reduced significantly lower than the dislocation density of a GaAs substrate. If a layer structure which can be utilized for electronic devices or optical devices is grown on the buffer layer of the present invention, a device excellent in properties manifesting no influence by dislocation can be produced, namely, such constitution is significantly valuable industrially. Further, when the buffer layers and epitaxial crystal layers of the present invention is used, an epitaxial crystal layers of lower dislocation density can be produced even on a GaAs substrate with high dislocation density, consequently, a device excellent in properties can be obtained, to increase the degree of freedom in selecting substrates. Namely, this epitaxial film has a remarkably large industrial value.

**Claims**

1. A 3-5 group compound semiconductor comprising a GaAs substrate, a buffer layer on said GaAs substrate and an epitaxial crystal layer on said buffer layer, said layers being formed by an epitaxial crystal growth method, wherein

said buffer layer and said epitaxial crystal layer on said buffer layer are 3-5 group compound semiconductors each independently represented by the general formula $In_xGa_yAl_zAs$ (wherein, $0 \leqq x \leqq 1$, $0 \leqq y \leqq 1$, $0 \leqq z \leqq 1$, x+y+z=1), and the dislocation density in the epitaxial crystal layer on said buffer layer is 2000/cm$^2$ or less.

2. A 3-5 group compound semiconductor comprising a GaAs substrate, a buffer layer on said GaAs substrate and an epitaxial crystal layer on said buffer layer, said layers being formed by an epitaxial crystal growth method, wherein

said buffer layer and said epitaxial crystal layer on said buffer layer are 3-5 group compound semiconductors each independently represented by the general formula $In_xGa_yAl_zAs$ (wherein, $0 \leqq x \leqq 1$, $0 \leqq y \leqq 1$, $0 \leqq z \leqq 1$, x+y+z=1), and the dislocation density in said epitaxial crystal layer on the buffer layer is 1/3 or less of the dislocation density in said GaAs substrate.

3. The 3-5 group compound semiconductor according to Claim 1 or 2 wherein said buffer layer has a structure formed by laminating at least two kinds of layers having different compositions, for n ($1 \leqq n \leqq 30$) times.

4. The 3-5 group compound semiconductor according to Claim 3 wherein said two kinds of layers are a $Ga_{l-z}Al_zAs$ layer (wherein, $0 < z \leqq 1$) and a GaAs layer.

5. The 3-5 group compound semiconductor according to Claim 4 wherein the value of said z is between 0.01 or more and 0.4 or less.

6. The 3-5 group compound semiconductor according to Claim 3 wherein at least one layer of said two kinds of layers is doped with an n-type dopant.

7. The 3-5 group compound semiconductor according to Claim 6 wherein said n-type dopant is Si and the concentration of this Si is between $1 \times 10^{17}$ cm$^{-3}$ or more and $5 \times 10^{18}$ cm$^{-3}$ or less.

8. The 3-5 group compound semiconductor according to Claim 3 wherein an n-type dopant is planar-doped in at least one layer of said two kinds of layers.

9. The 3-5 group compound semiconductor according to Claim 3 wherein an n-type dopant is planar-doped on the interface of at least one layer of said two kinds of layers.

10. The 3-5 group compound semiconductor according to Claim 8 or 9 wherein said n-type dopant is Si and the planar-doping concentration of this Si is between $1 \times 10^{11}$ cm$^{-2}$ or more and $5 \times 10^{12}$ cm$^{-2}$ or less.

11. A light-emitting element obtained by using the 3-5 group compound semiconductor of any of Claims 1 to 10.

12. A method of measurement of dislocation density in epitaxial crystal comprising the steps of: irradiating an epitaxial crystal with laser light having a wavelength shorter than that corresponding to the bandgap energy of crystal composition; measuring the in-surface distribution of the peak intensity of thus-obtained photo-luminescent light; and calculating the dislocation density ($N$ cm$^{-2}$) from the number ($n$) of dark spots or dark lines and the area ($S$ cm$^2$) of measurement region, according to the following formula (I).

$$N = n/S \qquad (I)$$

13. A method of measurement of dislocation density according to Claim 12, wherein the epitaxial crystal is composed of a plurality of layers, and the dislocation density is calculated for each layer.

Figure 1

| | |
|---|---|
| | 44 |
| Clad layer | 43 |
| Active layer | 42 |
| Clad layer | 41 |
| GaAs layer | 32 |
| Al0.2Ga0.8As layer | 31 |
| GaAs layer | 32 |
| Al0.2Ga0.8As layer | 31 |
| GaAs substrate | 2 |

4 (44, 43, 42, 41)

3 (32, 31, 32, 31)

Figure 2

1'

44
Clad layer — 43
Active layer — 42     } 4
Clad layer — 41

GaAs substrate — 2

Figure 3

GaAs substrate